# EUROPÄISCHE PATENTSCHRIFT

(11) **EP 2 379 852 B1**
(45) Veröffentlichungstag und Bekanntmachung des Hinweises auf die Patenterteilung: **17.08.2016**
(21) Anmeldenummer: 09768031.8
(22) Anmeldetag: 07.12.2009
(51) Int. Cl.: F01N 3/04, F01N 5/02, H01L 35/34

(54) **ABGASKÜHLER FÜR EINEN VERBRENNUNGSMOTOR**
EXHAUST COOLER FOR A COMBUSTION MOTOR
REFROIDISSEUR DE GAZ D'ÉCHAPPEMENT POUR UN MOTEUR À COMBUSTION INTERNE

(30) Priorität: 19.12.2008 DE 102008063701
(43) Veröffentlichungstag der Anmeldung: 26.10.2011
(73) Patentinhaber: MAHLE Behr GmbH & Co. KG, 70469 Stuttgart (DE)
(72) Erfinder: HECKENBERGER, Thomas, 5837 Fentange (LU); GESKES, Peter, 73760 Ostfildern (DE); BREHM, Holger, 71729 Erdmannhausen (DE); NEUMEISTER, Dirk, 70374 Stuttgart (DE)
(74) Vertreter: Grauel, Andreas
(86) Internationale Anmeldenummer: PCT/EP2009/066507
(87) Internationale Veröffentlichungsnummer: WO 2010/069801

(56) Entgegenhaltungen:
- EP-A1- 1 965 446
- WO-A2-2008/061823
- DE-A1- 10 041 955
- DE-A1-102006 039 024
- DE-A1-102006 057 662

## Beschreibung

Die Erfindung betrifft einen Abgaskühler für einen Verbrennungsmotor nach dem Oberbegriff des Anspruchs 1

Grundsätzlich ist es diskutiert worden, die Abwärme von Verbrennungsmotoren zum Betrieb von thermoelektrischen Elementen, zum Beispiel Seebeck-Elementen, zu nutzen. Hierdurch kann der Gesamtwirkungsgrad des Verbrennungsmotors verbessert werden. Unter anderem Kosten und baulicher Aufwand von zur Verfügung stehenden thermoelektrischen Elementen haben bisher serientaugliche Lösungen verhindert.

DE102006039024 A1 beschreibt einen Thermogenerator mit einer Kühlvorrichtung.

DE 10 2006 055 120 A1 beschreibt eine thermoelektrische Folie, die aufgrund Ihrer Beschaffenheit hohen Temperaturen stand hält und zudem eine ausreichende mechanische Flexibilität zur Aufbringung auch auf gekrümmte oder gewinkelte Flächen aufweist. Eine thermoelektrische Folie im Sinne der vorliegenden Erfindung ist als eine Folie gemäß der Druckschrift DE 10 2006 055 120 A1 definiert. Zumindest in geeigneten Ausführungsformen hat die Folie eine ausreichende Temperaturbeständigkeit zum Betrieb mit heißem Abgas als Wärmequelle.

Es ist die Aufgabe der Erfindung, einen Abgaskühler für einen Verbrennungsmotor anzugeben, mittels dessen die Wärmeenergie des Abgases zum Teil in eine höherwertige Energieform umwandelbar ist.

Diese Aufgabe wird für einen eingangs genannten Wärmetauscher erfindungsgemäß mit den kennzeichnenden Merkmalen des Anspruchs 1 gelöst. Durch das Belegen der Wand mit der flexiblen thermoelektrischen Folie kann kostengünstig und effektiv ein großflächiges thermoelektrisches Element im Abgasstrom des Motors angeordnet werden. Da der Abgaskühler regelmäßig schon aus anderen Gründen wie etwa der Abgasrückführung zur Schadstoffreduzierung vorgesehen ist, fällt außer der Bereitstellung der Folie und gegebenenfalls einer Steuerelektronik zur Einspeisung des aus ihr entnommenen Stromes etwa in ein Bordnetz kaum zusätzlicher baulicher Aufwand an. Zugleich überströmt das Abgas in einem solchen Abgaskühler eine besonders große Oberfläche bzw. Wand des Strömungskanals, so dass eine hohe elektrische Leistung generierbar ist. Weiterhin wird durch das Kühlfluid eine leistungsfähige und definierte Wärmesenke für das thermoelektrische Element bereitgestellt.

Bei einer bevorzugten Ausführungsform der Erfindung ist das Fluid ein flüssiges Kühlmittel eines Kühlmittelkreislaufs, wodurch ein besonders großer lokaler Temperaturunterschied bei zugleich großer Kühlleistung gegeben ist.

Bei einer möglichen Ausführungsform der Erfindung ist der Abgaskühler als Rohrbündel-Wärmetauscher ausgebildet, wobei die Wand jeweils als Wandung eines von mehreren Tauscherrohren ausgebildet ist. Bei einer alternativen Ausführungsform der Erfindung ist der Abgaskühler als Scheiben-Wärmetauscher ausgebildet, wobei die Wand jeweils als Fläche einer Stapelscheibe des Wärmetauschers ausgebildet ist. Sowohl im Fall von Tauscherrohren als auch im Fall von Stapelscheiben lässt sich die flexible thermoelektrische Folie einfach und sicher auf den wärmeführenden Oberflächen bzw. die zwischen Abgas und Kühlfluid angeordnete Wand aufbringen.

Bei einer allgemein besonders bevorzugten Ausführungsform ist die thermoelektrische Folie zumindest abgasseitig auf der Wand aufgebracht. Hierdurch lässt sich eine besonders große Temperaturdifferenz zwischen den gegenüberliegenden Oberflächen der Folie und somit ein besonders großer Wirkungsgrad erzielen.

Weitere Vorteile und Merkmale der Erfindung ergeben sich aus dem nachfolgend beschriebenen Ausführungsbeispiel sowie aus den abhängigen Ansprüchen.

Nachfolgend wird ein bevorzugtes Ausführungsbeispiel der Erfindung beschrieben und anhand der anliegenden Zeichnung näher erläutert.

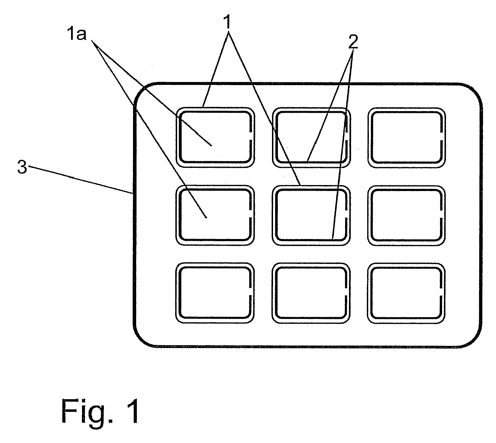

- Fig. 1: zeigt eine teilweise Schnittansicht eines erfindungsgemäßen Abgaskühlers.

Der in Fig. 1 gezeigte Abgaskühler ist als Rohrbündel-Wärmetauscher ausgebildet, bei dem eine Mehrzahl von parallelen Tauscherrohren 1, die jeweils einen Strömungspfad 1a ausbilden, in einem kühlmitteldurchströmten Gehäuse bzw. Wassermantel 3 angeordnet sind. Die Tauscherrohre 1 werden von Abgas eines Verbrennungsmotors eines Kraftfahrzeugs durchströmt, um Wärme des Abgases durch die Wände der Tauscherohre 1 an das Kühlmittel abzugeben. Das gekühlte Abgas wird nachfolgend zumindest teilweise dem Verbrennungsmotor eingangsseitig zugeführt, zum Beispiel um bei Dieselmotoren die Emission von Stickoxiden zu reduzieren.

Auf der abgasseitigen Innenseite der Tauscherrohre 1 ist jeweils eine flexible thermoelektrische Folie 2 aufgebracht. Die Folie 2 steht dabei in möglichst gutem thermischen Kontakt mit der Wand des Tauscherrohrs. Je nach Auslegung der Folie kann der Kontakt thermisch und mechanisch zum Beispiel durch flächige Verlötung ausgebildet sein.

An vorgesehenen Kontaktstellen (nicht dargestellt) sind die Folien elektrisch kontaktiert, so dass ihnen bei Betrieb des Abgaskühlers elektrische Energie entnommen werden kann. Diese Energie kann in einen Stromkreis des Fahrzeugs eingespeist werden, wozu gegebenenfalls eine entsprechende Regelelektronik vorgesehen ist.

Je nach Anforderungen können auch mehrere Folien übereinander angeordnet sein und alternativ oder ergänzend kann auch auf der Kühlmittelseite der Tauscherrohre eine Folie vorgesehen sein.

## Patentansprüche

1. Abgaskühler für einen Verbrennungsmotor, umfassend einen Strömungspfad (1a) zur Führung von Abgas eines Verbrennungsmotors,
wobei der Strömungspfad eine Wand (1) zur Trennung des Abgasstroms von einem Kühlfluid aufweist, und
wobei über die Wand (1) Wärme zwischen dem Abgas und dem Kühlfluid austauschbar ist,
**dadurch gekennzeichnet,**
**dass** die Wand (1) zumindest teilweise mit einer flexiblen thermoelektrischen Folie (2) flächig belegt ist.

2. Abgaskühler nach Anspruch 1, **dadurch gekennzeichnet, dass** das Fluid ein flüssiges Kühlmittel eines Kühlmittelkreislaufs ist.

3. Abgaskühler nach einem der vorhergehenden Ansprüche, **dadurch gekennzeichnet, dass** der Abgaskühler als Rohrbündel-Wärmetauscher ausgebildet ist, wobei die Wand jeweils als Wandung eines von mehreren Tauscherrohren (1) ausgebildet ist.

4. Abgaskühler nach einem der Ansprüche 1 oder 2, **dadurch gekennzeichnet, dass** der Abgaskühler als Scheiben-Wärmetauscher ausgebildet ist, wobei die Wand jeweils als Fläche einer Stapelscheibe des Wärmetauschers ausgebildet ist.

5. Abgaskühler nach einem der vorhergehenden Ansprüche, **dadurch gekennzeichnet, dass** die thermoelektrische Folie (2) zumindest abgasseitig auf der Wand (1) aufgebracht ist.

## Claims

1. An exhaust gas cooler for an internal combustion engine, comprising
a flow path (1a) for guidance of the exhaust gas from an internal combustion engine,
wherein the flow path comprises a wall (1) for separating the exhaust gas flow from a cooling fluid, and
wherein heat can be exchanged between the exhaust gas and the cooling fluid via the wall (1), **characterised in that**
the wall (1) is covered at least partially by a flexible thermoelectric foil (2).

2. The exhaust gas cooler according to claim 1, **characterised in that** the fluid is a liquid coolant of a coolant circuit.

3. The exhaust gas cooler according to one of the preceding claims, **characterised in that** the exhaust gas cooler is in the form of a bundle heat exchanger, wherein each wall is designed as a wall of one of a plurality of exchanger tubes (1).

4. The exhaust gas cooler according to one of claims 1 or 2, **characterised in that** the exhaust gas cooler is in the form of a plate heat exchanger, wherein each wall is designed as the surface of a plate stack of the heat exchanger.

5. The exhaust gas cooler according to one of the preceding claims, **characterised in that** the thermoelectric foil (2) is applied to the wall (1) at least on the exhaust-gas side.

## Revendications

1. Refroidisseur de gaz d'échappement pour un moteur à combustion interne, comprenant un chemin d'écoulement (1a) servant au guidage de gaz d'échappement d'un moteur à combustion interne,
où le chemin d'écoulement présente une paroi (1) servant à la séparation du flux de gaz d'échappement, d'un fluide de refroidissement, et
où de la chaleur, passant par la paroi (1), peut être échangée entre les gaz d'échappement et le fluide de refroidissement,
**caractérisé**
**en ce que** la paroi (1) est dotée sur sa surface, au moins partiellement, d'une feuille thermoélectrique flexible (2).

2. Refroidisseur de gaz d'échappement selon la revendication 1, **caractérisé en ce que** le fluide est un moyen de refroidissement liquide d'un circuit du moyen de refroidissement.

3. Refroidisseur de gaz d'échappement selon l'une des revendications précédentes, **caractérisé en ce que** le refroidisseur de gaz d'échappement est conçu comme un échangeur de chaleur à faisceaux de tubes, où la paroi est conçue à chaque fois comme une paroi de séparation d'un parmi plusieurs tubes d'échangeur (1).

4. Refroidisseur de gaz d'échappement selon l'une des revendications 1 ou 2, **caractérisé en ce que** le refroidisseur de gaz d'échappement est conçu comme un échangeur de chaleur à plaques, où la paroi est conçue à chaque fois comme une surface d'une plaque d'empilage de l'échangeur de chaleur.

5. Refroidisseur de gaz d'échappement selon l'une quelconque des revendications précédentes, **caractérisé en ce que** la feuille thermoélectrique (2) est appliquée sur la paroi (1), au moins côté gaz d'échappement.
